# EUROPEAN PATENT APPLICATION

(11) **EP 2 175 694 A1**
(43) Date of publication of application: **14.04.2010**
(21) Application number: 08777668.8
(22) Date of filing: 27.06.2008
(51) Int. Cl.: H05B 33/10, H01L 21/336, H01L 29/786, H01L 51/50

(54) **METHOD FOR FORMING THIN FILM, METHOD FOR MANUFACTURING ORGANIC ELECTROLUMINESCENT DEVICE, METHOD FOR MANUFACTURING SEMICONDUCTOR DEVICE, AND METHOD FOR MANUFACTURING OPTICAL DEVICE**

(30) Priority: 28.06.2007 JP 2007170487
(71) Applicant: Sumitomo Chemical Company, Limited, Tokyo 104-8260 (JP)
(72) Inventor: ITO, Norihito, Misato-shi Saitama 341-0012 (JP)
(74) Representative: Duckworth, Timothy John
(86) International application number: PCT/JP2008/061756
(87) International publication number: WO 2009/001935

(57) **Abstract**

The present invention has the object of providing a method by which a thin film pattern can be formed using a liquid material application in a prescribed area in an economical and simple manner, and a method for producing organic electroluminescent devices, semiconductor devices, and optical devices using said method.

A method by which a liquid material 16a containing a thin film forming material is applied to a substrate 11 to form a thin film in a prescribed region, comprising: a step of subjecting the substrate 11 to lyophobization to make a lyophobized surface A; a step of patterning an underlayer 15 on the lyophobized surface A of the substrate 11, the underlayer 15 being more lyophilic to the liquid material 16a than the lyophobized surface A; and a step of applying the liquid material 16a to the underlayer 15 and then drying it.

## Description

### Field of the Invention

The present invention relates to a thin film forming method, an organic electroluminescent device producing method, a semiconductor device producing method, and an optical device producing method, and more particularly to a method for forming a thin film patterned by a applying method using a liquid material, and a producing method for an organic electroluminescent device, a semiconductor device, and an optical device using that method.

### Explanation of the Prior Art

The production of light-emitting elements, semiconductor devices, and optoelectric conversion devices or other functional devices using organic materials has drawn attention in recent years. This is because forming organic material thin films by application methods allows the fabrication of large area functional elements with an organic material layer (functional layer). In such cases, the organic material layer is generally patterned on the substrate of the above functional element.

In Patent Documents 1 and 2, relative to the forming of a thin film pattern of organic material, a pattern defined within a region contained between partitioning walls is first formed on a substrate; a liquid material containing organic light-emitting material is then applied in the region contained between those partitioning walls, then dried to form on the substrate an organic light-emitting layer pattern comprising organic material.

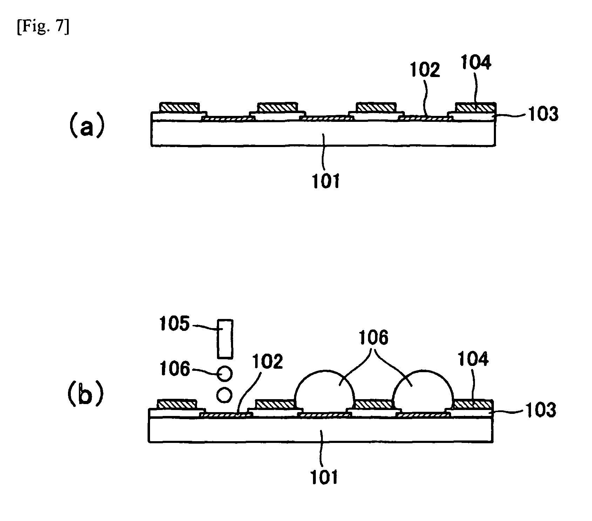

Fig. 7 describes an overview of the functional layer pattern forming method using the conventional art described above. As shown in Fig. 7(a), electrodes 102 of ITO film or the like and inorganic insulating layers 103 for insulating between adjacent electrodes 102 are first formed on the substrate 101, and organic partitioning wall layers 104 of an organic material is then further formed on the inorganic insulating layers 103. The inorganic insulating layers 103 and the organic partitioning wall layers 104 are lyophilic with respect to the liquid materials above.

In this state, the surface of the substrate 101 is subjected to CF₄ plasma gas treatment (lyophobization treatment). In the CF₄ plasma treatment, the inorganic material surface (inorganic insulating layers 103, electrodes 102) is less subject to fluorination than the organic material surface (organic partitioning wall layers 104). Following this treatment, therefore, on the substrate 101, the lyophilic characteristic of the inorganic surface is retained against the above liquid material, but the organic material surface is lyophobic, so that the surface state can be selectively changed.

Next, as shown in Fig.7(b), a liquid material 106 is jetted between organic partitioning wall layers 104 by an ink jet method using an ink jet head 105. The jetted liquid material 106 is repelled by the lyophobic organic partitioning wall layers 104, and is held on by the lyophilic electrodes 102 and inorganic insulating layers 103 while being partitioned by the organic partitioning wall layers 104. Thus, A light-emitting layer, which is the functional layer, can be patterned on the electrodes 102 by drying the held liquid material 106.
Patent Document 1: Patent Unexamined Publication No. 2000-323276
Patent Document 2: Patent Unexamined Publication No. 2002-222695

### Disclosure of the Invention

### Problems to be Solved by the Invention

In the method of the above conventional art, organic partitioning wall layers 104 had to be formed on the substrate 101 by photolithography or the like to define a prescribed pattern using this organic partitioning wall layers 104, leading to greater numbers of process steps and reduced yields.

The present invention was undertaken to solve problems of this type, and has the objects of providing a method by which a thin film pattern can be formed using a liquid material application in a prescribed area in an economical and simple manner, and a method for producing organic electroluminescent devices, semiconductor devices, and optical devices using said method.

### Means for Solving the Problems

To achieve the above objects, the present invention is a method by which a liquid material containing a thin film forming material is applied to a substrate to form a thin film in a prescribed region, the method comprising: a step of subjecting the substrate to lyophobization; a step of patterning an underlayer on a lyophobized surface of the substrate, the underlayer being more lyophilic to the liquid material than the lyophobized surface; and a step of applying the liquid material to the underlayer and then drying it.

In the present invention thus constituted, prior to forming a thin film by applying a liquid material onto a prescribed region of the substrate, a lyophobized surface is formed on the substrate by a lyophobization treatment, either directly or indirectly through another layer, and the underlayer is patterned on this lyophobized surface. The liquid material is then applied onto the pattern of the lyophilic underlayer. The liquid material thus does not flow onto the lyophobized surface formed on the substrate, but stops on the lyophilic underlayer, and a desired thin film pattern can be formed by drying this liquid material. In the present invention, the region used to form the thin film by the application method is defined by the underlayer, so there is no need to form partitioning walls, and the substrate structure can be simplified. The present invention thus enables the production process to be streamlined, thereby preventing a reduction in product yield and lowering production costs.

In the present invention the underlayer is preferably formed by a dry method in the step of patterning the underlayer. In the present invention thus constituted, use of a dry method rather than an application method enables the underlayer to be formed without being affected by the wettability of the surface on which the underlayer is formed. Generally used methods such as vapor deposition, sputtering, and CVD may be used for the dry method. A mask in which aperture portions form the deposited region may, for example, be used in a dry method for patterning the underlayer.

Furthermore, in the present invention the underlayer is preferably a layer comprised of a metal oxide or a metal composite oxide, and more specifically, the underlayer is any of vanadium oxide, molybdenum oxide, ruthenium oxide, aluminum oxide, nickel oxide, barium titanate, and strontium titanate. In the present invention thus constituted, the underlayer material can be appropriately selected in accordance with the element or device being produced; for example when producing an electronic device, one of the above metal oxides or metal composite oxides can be selected. In other words, the metal oxides and metal composite oxides are stable materials amenable to charge injection and transport, and electronic devices can be produced by forming thin films of semiconductor material or optoelectric converting material on an underlayer formed of these materials.

In the present invention, the underlayer is preferably a layer comprising an organic material insoluble in the liquid material. In the present invention thus constituted, even though the thin film is formed by an application method on the underlayer, the underlayer is insoluble in the liquid material, therefore the underlayer can be maintained in a favorable state just as when the thin film is formed on the underlayer using vapor deposition or the like.

In the present invention, it is preferable that an edge of the underlayer be formed into a forward tapered shape in the step of patterning the underlayer. In the present invention thus constituted, level differences at the boundary between the lyophobized surface on the substrate and the lyophilic underlayer are unlikely to occur, therefore the liquid material can be reliably held at the boundary portion of the underlayer.

In the present invention it is preferable that a pattern of the underlayer be formed in the same region of the thin film as the prescribed region in the step of patterning the underlayer.
In the present invention it is also preferable that a pattern of the underlayer be formed on an electrically conductive material partitioned with an insulating material in the step of patterning the underlayer.

In the present invention it is further preferable that the lyophobization is a vacuum plasma treatment including a fluorine-containing gas, an atmospheric pressure plasma treatment including a fluorine-containing gas, or a treatment comprising applying a lyophobic material to the substrate. In the present invention thus constituted, when the surface which is to be subjected to lyophobization is formed of an organic substance, a selection can be made from the above plasma treatment and applying lyophobic materials. On the other hand, when the surface which is to be subjected to lyophobization is formed of an inorganic substance such as a metal or a metal oxide, since the surface is hard to be fluorinated in the plasma treatment and is hard to be subjected to lyophobization, lyophobization is performed by applying lyophobic materials.

It is further preferable in the present invention that the step of applying the liquid material and drying it be repeated multiple times using the same liquid material. In the present invention thus constituted, unevenness in application quantities can be dispersed by multiple applications of the same material, thereby forming a more uniform thin film.

It is further preferable in the present invention that the step of applying the liquid material and drying it be repeated multiple times using different liquid materials. In the present invention thus constituted, a thin film with a more complex layer structure can thus be formed.

The method for producing an organic electroluminescent device, a semiconductor device, or an optical device of the present invention uses the above thin film forming method. In the present invention thus constituted, a thin film is patterned in a prescribed region on a substrate in an economical and simple manner using a liquid material by an application method, therefore production steps can be simplified, product yield loss can be reduced, and production costs can be lowered.

### Effect of the Invention

The present invention provides a method for forming a thin film in a prescribed region on a substrate in an economical and simple manner using a liquid material and an application method. The present invention also provides a method for producing an organic electroluminescent device, semiconductor device, or optical device using the above method.

### Embodiments of the Invention

Below we discuss embodiments of the present invention with reference to the attached figures. The thin film forming method of the present invention is one which forms fine prescribed patterns of a thin film layer by applying a liquid material onto a substrate and drying that material without forming partitioning portions on the substrate, therefore as shown in the embodiments below, it can be applied to light-emitting elements, semiconductor devices, optical devices, and the like.

### (First Embodiment)

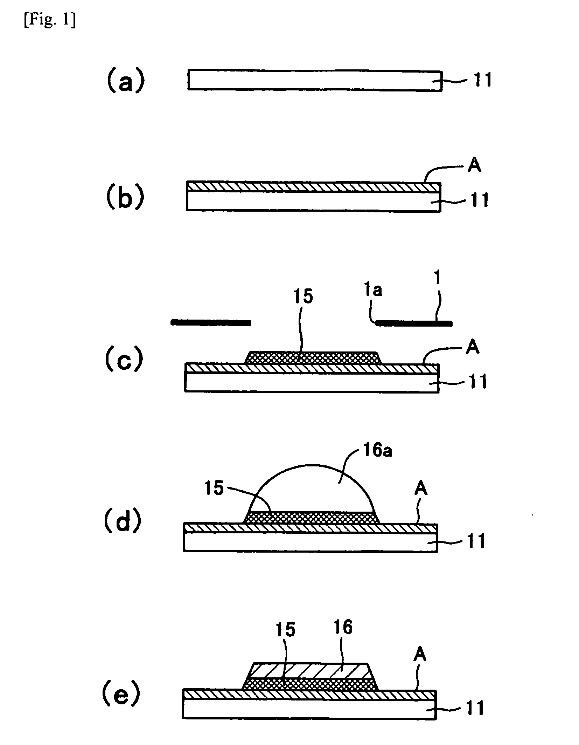

First, referring to Fig.1, we discuss a thin film forming method according to a first embodiment of the present invention. In the first embodiment, a thin film layer is formed on the substrate using the thin film forming method of the present invention. Fig.1 shows the process steps for forming a thin film according to the first embodiment of the present invention.

Fig. 1(e) shows a thin film layer 16 formed on a substrate 11 according to the first embodiment. The thin film 16 corresponds to the thin film formed in a prescribed region or a prescribed pattern in the present invention. In this embodiment, the thin film 16 is formed on an underlayer 15 formed in a prescribed pattern on the substrate 11. The thin film 16 is thus formed to have the same pattern as the underlayer 15 on the substrate 11.

The substrate 11 is a transparent glass substrate. The substrate 11 can be a flexible material or a hard material, and may, in addition to glass, consist of plastic, polymer film, silicon, or metal substrate or the like. The substrate 11 may also be one of various types of substrates such as a semiconductor integrated circuit substrate or a substrate on which electrodes and the like are patterned.

There is no particular limitation as to the material used for the underlayer 15, which may be an inorganic material or an organic material or the like. It is desirable that the underlayer 15 be insoluble in the solvent used to constitute the liquid material described below. Note that when the present embodiment is used to produce an electronic device such as an organic EL device or a semiconductor device, an electron injection/transport material or hole injection/transport material may be used as the underlayer 15.

Metal oxides and metal composite oxides can be used as the inorganic materials for such purposes.
Specific examples of the above metal oxides may include oxides of chrome (Cr), molybdenum (Mo), tungsten (W), vanadium (V), niobium (Nb), tantalum (Ta), titanium (Ti), zirconium (Zr), hafnium (Hf), scandium (Sc), yttrium (Y), thorium (Th), manganese (Mn), iron (Fe), ruthenium (Ru), osmium (Os), cobalt (Co), nickel (Ni), copper (Cu), zinc (Zn), cadmium (Cd), aluminum (Al), gallium (Ga), indium (In), silicon (Si), germanium (Ge), tin (Sn), lead (Pb), antimony (Sb), bismuth (Bi), and from lanthanum (La) to lutetium (Lu).

In addition to barium titanate (BaTiO₃) and strontium titanate (SrTiO₃), some specific examples of the above metal composite oxides include calcium titanate (CaTiO₃), potassium niobate (KNbO₃), bismuth ferrite (BiFeO₃), lithium niobate (LiNbO₃), sodium vanadate (Na₃VO₄), iron vanadate (FeVO₃), titanium vanadate (TiVO₃), chromium vanadate (CrVO₃), nickel vanadate (NiVO₃), magnesium vanadate (MgVO₃), calcium vanadate (CaVO₃), lanthanum vanadate (LaVO₃), vanadium molybdate (VMoO₅), vanadium molybdate (V₂MoO₈), lithium vanadate (LiV₂O₅), magnesium silicate (Mg₂SiO₄), magnesium silicate (MgSiO₃), zirconium titanium oxide (ZrTiO₄), strontium titanate (SrTiO₃), lead magnesate (PbMgO₃), lead niobate (PbNbO₃), barium borate (BaB₂O₄), lanthanum chromium oxide (LaCrO₃), lithium titanate (LiTi₂O₄), lanthanum cupric oxide (LaCuO₄), zinc titanate (ZnTiO₃), calcium tungstate (CaWO₄).

Among the above examples, vanadium oxide, molybdenum oxide, ruthenium oxide, aluminum oxide, nickel oxide, barium titanate, and strontium titanate are particularly desirable.

Regarding organic substance-based materials, the following dye materials are specific examples of hole injection/transport materials: phenylamine compounds, starburst-type amine compounds, phthalocyanine compounds, amorphous carbon, cyclopendamine derivatives, tetraphenylbutadiene derivative compounds, triphenylamine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, trifumanylamine derivatives, oxadiazole dimmers, and pyrazoline dimmers. Other examples include metal complex materials such as quinolinol aluminum complexes, benzoquinolinol beryllium complexes, benzoxazolyl zinc complexes, benzothiazole zinc complexes, azomethyl zinc complexes, porphyrin zinc complexes, europium complexes, and the like, the metal complex materials having a central metal such as Al, Zn, or Be, or the like or rare earth metals such as Tb, Eu, or Dy, and ligands such as oxadiazole, thiadiazole, pheylpyridine, pheyl benzoimidazole, quinoline or other structures.
Further examples of electron injection/transport materials include substances forming generally stable radical anions with large ionization potentials, such as oxadiazoles and quinolinol aluminum complexes. More specifically, these include 1, 3, 4-oxadiazole derivatives and 1,2,4-triazole derirvatives, as well as imidazole derivatives.

A thin film 16 is formed by applying a liquid material onto the underlayer 15 and drying. The liquid material is formed by adding a thin film forming material to a solvent. There is no particular limitation on the solvent; either an aqueous or an organic solvent may be used so long as it does not dissolve the underlayer 15. Additives such as surfactants may also be added as needed to achieve uniform applying and drying of the liquid.

A material which is soluble or dispersible in a solvent, such as an organic material, an inorganic material, or an organic/inorganic hybrid material may be used as the thin film forming material. When the object to be produced is an organic EL device, organic EL material can be used for the thin film forming material.

Next we discuss the thin film forming method of the first embodiment, based on Fig.1.
First, a substrate 11 is prepared (Fig. 1 (a)), and the substrate 11 is subjected to lyophobization (Fig. 1 (b)). The reference symbol A in Fig.1 indicates that the surface of the substrate 11 is lyophobized or lyophobic.

In the present Specification, the term "lyophobized or lyophobic" means that the affinity of the target surface (substrate 11) is low relative to the liquid material (or the solvent therein) which contains the material for forming the thin film 16. Whether being lyophobized (or lyophobic) or not can be determined by the contact angle between the liquid material and the substrate 11. The contact angle is defined as the angle at which droplets of liquid dropped onto a solid surface contact that solid surface.

If, in the present Specification, the contact angle of liquid droplet is 30° or greater, the liquid is defined to be lyophobic or liquid-repellency (liquid-repulsed) by the solid surface. When the contact angle is less than 30°, the liquid has affinity for the solid surface, which is defined as being easily wettable. If this is the case, an applied liquid will spread uniformly on the solid surface, forming a good quality film.

Lyophobization treatments include plasma treatment including a fluorine-containing gas, and a method in which a lyophobic material is applied; a selection can be appropriately made from these based on the material of the surface which is to be subjected to lyophobization.
In other words, when the surface which is to be subjected to lyophobization is formed of an organic material, both the method in which a lyophobic material is applied and the method of plasma treatment including a fluorine-containing gas can be selected as the lyophobization treatment. A vacuum plasma or atmospheric pressure plasma using a fluorine-containing gas such as CF₄ or SF₆ can be applied as the plasma treatment including fluorine-containing gas.

On the other hand, when the surface to be subjected to lyophobization is formed of an inorganic material, the surface will tend not to become fluorinated even under a plasma treatment including fluorine-containing gas, thereby it is difficult to be lyophobizad; it is therefore preferable to perform lyophobization treatment by applying a lyophobic material. A fluorinated resin having fluorine within its molecule, a surfactant, or a silane coupling material or the like may be used as the lyophobic material.

In the example shown in Fig. 1(b), the substrate 11, which is the surface to be subjected to lyophobization, is formed of an inorganic material, therefore a lyophobic material is applied onto the surface of the substrate 11. The substrate 11 thus is lyophobized, and a lyophobized surface A is formed on the surface thereof.

Next, an underlayer 15 is formed on the lyophobized surface A of the substrate 11 (Fig. 1 (c)).
In this step, a mask 1 with an aperture portion 1 a is disposed above the substrate 11, and an underlayer 15 is formed by vacuum deposition. The purpose of the underlayer 15 is to facilitate the disposition of liquid material that forms the thin film layer 16 thereon in subsequent steps; it provides a lyophilic surface.
It is desirable that the underlayer 15 be formed by a dry method so that the film can be formed without being affected by the wettability of the substrate 11. More specifically, in addition to vacuum deposition methods, sputtering, ion plating, and CVD methods are desirable. The underlayer 15 can also be constituted by laminating multiple material layers.

As shown in Fig.1(c), it is desirable that the edge of the underlayer 15 be formed to have a forward tapered shape of less than 90°. In other words, the underlayer 15 should be formed so that at its edge it grows thinner toward the border (tip) contacting the substrate 11. The underlayer 15 gradually thickens in the edge from the border toward the center of the underlayer 15. Forming the edge of the underlayer 15 in a forward tapered shape in this way makes it difficult for level differences to arise at the border portion between the lyophobized surface A of the substrate 11 and the underlayer 15, therefore the liquid material can be reliably held at the border portion of the underlayer 15.

In addition to the method discussed above which uses a mask 1 in which the film deposition region is the aperture portion, it is also possible to adopt as a method for forming an underlayer 15 of a prescribed pattern a method in which the underlayer 15 is patterned by a photolithography step following the formation of the underlayer on the entire surface of the substrate 11.

Next, a liquid material 16a is applied onto the underlayer 15 which is a lyophilic region by an application method (Fig.1(d)).
The underlayer 15 is lyophilic and the surrounding surface of the substrate 11 (the lyophobized surface A) is lyophobic. Therefore, due to its repulsion from the lyophobized substrate 11, the liquid material 16a applied onto the underlayer 15 does not flow onto the substrate 11, seeking instead to concentrate on the lyophilic underlayer 15.
The liquid material 16a is thus disposed on the patterned underlayer 15.

Methods for applying the liquid material 16a include ink jet method, nozzle coating, dispensing, bar coating, blade coating, roll coating, gravure coating, flexo printing, and spray coating.

The liquid material 16a is then dried to form a thin film layer 16 on the underlayer 15 (Fig. 1(e)).
The thin film layer 16 comprising thin film forming material is formed on the underlayer 15 by drying the liquid material 16a. The liquid material 16a can be dried using a drying mechanism such as a hot plate, oven, or dryer while temperature is controlled with a temperature control mechanism attached to a stage (not shown) for holding the substrate 11.

Note that the applying step and drying step of the liquid material 16a may be repeated multiple times. Such repetition allows a thin film layer 16 of desired thickness to be obtained and, by dispersing application unevenness, enables the formation of a thin film layer 16 with a uniform thickness.
The applying step and drying step may also be repeated multiple times using different liquid materials 16a. A more complexly structured thin film layer 16 can be formed by using multiple types of liquid materials 16a in this manner.

### (Second Embodiment)

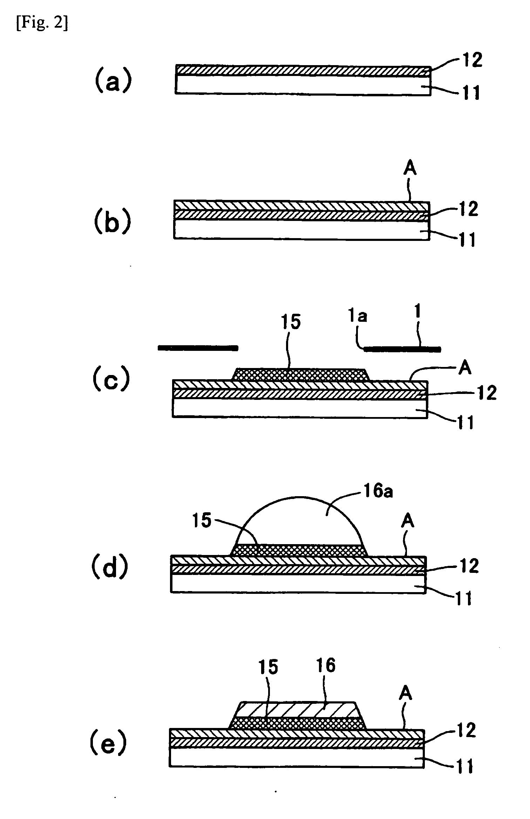

Next, referring to Fig.2, we explain a thin film forming method according to a second embodiment of the present invention.
In the second embodiment, a thin film of a desired pattern shape is formed on a substrate on which a desired material layer is formed. Fig.2 shows thin film forming steps according to the second embodiment of the present invention. Note that in the embodiments described below the same reference numerals are used for constituent elements which are the same as the first embodiment, and redundant explanations are omitted.

First, as shown in Fig.2(a), a substrate 11 is prepared on which a material layer 12 is formed. The material layer 12 may be an inorganic material, an organic material, or a mixed inorganic and organic material; there is no particular limitation with respect to materials.
Next, as shown in Fig. 2(b), the surface of the substrate 11, which is to say the material layer 12, is subjected to lyophobization, forming a lyophobized surface A. When the material layer 12 is an inorganic material layer, applying a lyophobic material is the desirable method for performing the lyophobization treatment, whereas when the material layer 12 is an organic material layer, either the method in which a lyophobic material is applied, or the plasma treatment including fluorine-containing gas may be used as appropriate.

Next, as shown in Fig.2(c), the mask 1 is disposed on the substrate 11, and the underlayer 15 is formed with a desired pattern on the lyophobized surface A of the material layer 12 using a dry method such as vacuum deposition or the like.
Then, as shown in Fig.2(d), the liquid material 16a is applied onto the underlayer 15 having a lyophilic surface. Since at this point the surface of the material layer 12 around the underlayer 15 is lyophobic, the liquid material 16a is disposed on the lyophilic surface of the underlayer 15.

Next, as shown in Fig.2(e), the liquid material 16a disposed on the underlayer 15 is dried. This enables, on the prescribed pattern-bearing underlayer 15, the formation of a thin film layer 16 having the same pattern.

### (Third Embodiment)

Next, referring to Figs.3 through 5, we discuss a thin film forming method according to a third embodiment of the present invention.
The third embodiment is an embodiment for producing an organic electroluminescent device using the thin film forming method of the present invention. Fig.3 is a cross-section of an organic electroluminescent device produced according to the third embodiment of the present invention; Figs.4 and 5 are a cross-section and plan view depicting production steps therein.

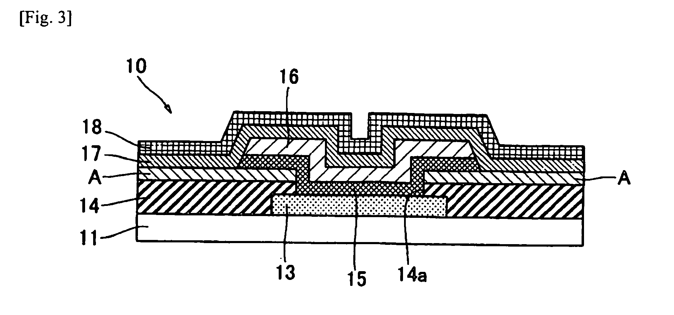

The organic electroluminescent device 10 (hereinafter "organic EL device 10") shown in Fig.3 has a substrate 11, an electrode 13, an insulating layer 14, an underlayer 15, a thin film layer 16, an electrode 17, and an oxide protective layer 18.

The electrode 13 is made of a conductive material and is formed in a prescribed pattern on the substrate around 11.
The insulating layer 14 is made of a material with electrically insulating properties, and is formed on the substrate 11 and the electrode 13. The insulating layer 14 covers the substrate 11 and the edges of the electrode 13; part of the electrode 13 is exposed by the aperture portion 14a.
The underlayer 15 is formed to cover the exposed portion of the electrode 13 exposed by the aperture portion 14a and the insulating layer 14 around the aperture portion 14a.

In the present embodiment, the thin film layer 16 is a light-emitting layer comprising a light-emitting material containing organic EL material, and is formed on the underlayer 15. The thin film 16 is formed by drying a solution (liquid material 16a) in which the light-emitting material is mixed into a solvent.
The electrode 17 comprises a conducting material, and is formed in a prescribed pattern on the thin film layer 16 and the insulating layer 14. The oxide protective layer 18 is formed to cover the substrate 11 containing electrode 17 and the like.
Using this structure, the organic EL device 10 shown in Fig.3 can emit light externally from the thin film layer 16 by sourcing current between electrodes 13 and 17.

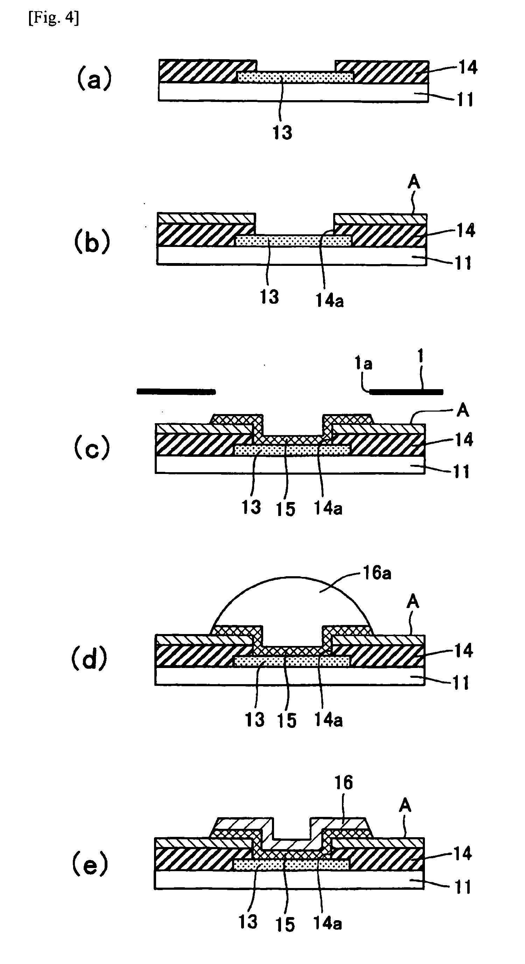

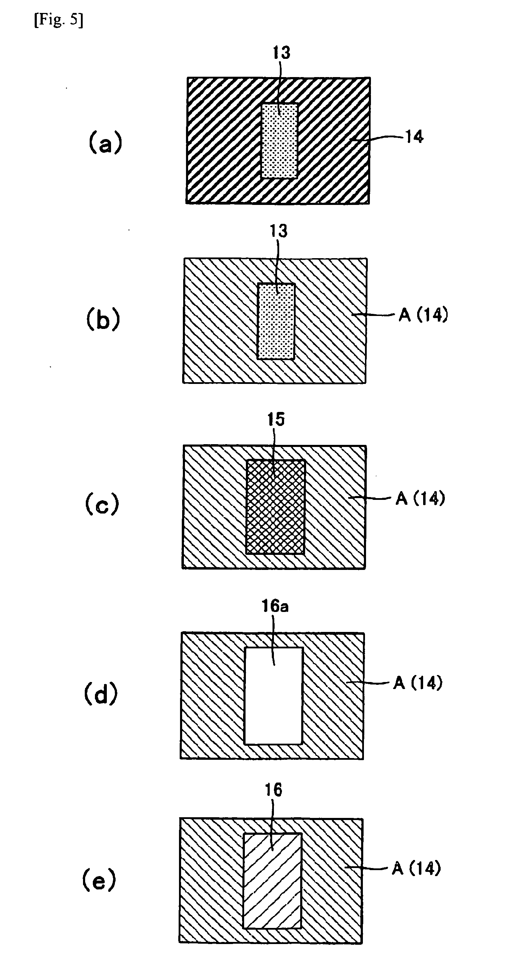

Referring to Figs.4 and 5, we next discuss a method for producing an organic EL device 10.
First, a substrate 11 is prepared and an electrode 13 and insulating layer 14 are formed on that substrate 11 (Fig.4(a), Fig.5(a)).
Next, the substrate 11 is subjected to lyophobization (Fig.4(b), Fig.5(b)).
In the present embodiment, the insulating layer 14 is formed of an organic material, and the electrode 13 is formed of an inorganic material. In this example, the surface to be subjected to lyophobization (insulating layer 14) is formed of an organic material, therefore a plasma treatment including a fluorine-containing gas is used on the surface of the substrate 11. The lyophilic surface of the insulating layer 14 is thus lyophobized and becomes the surface A. The reference numeral "A(14)" in Figs.5(b) through 5(e) indicates that the surface of the insulating layer 14 is the lyophobized surface A. Since the electrode 13 is formed of an inorganic material, the electrode 13 will remain a lyophilic surface even when subjected to plasma treatment.
The surfaces of the insulating layer 14 and the electrode 13 may be subjected to lyophobization by applying a lyophobic material.

If, unlike the present embodiment, the insulating layer 14 and the electrode 13 are both formed of an inorganic material, the surface to be subjected to lyophobization (insulating layer 14) will be formed of an inorganic material, therefore a treatment is performed to apply a lyophobic material on the surface of the substrate 11. The surfaces of the insulating layer 14 and the electrode 13 thus become lyophobic.

Next, the underlayer 15 is formed (Fig.4(c), Fig.5(c)).
In the present embodiment, the mask 1 is arranged to face the aperture portion 14a and its surrounding insulating layer 14, and the underlayer 15 is deposited using vacuum deposition. The underlayer 15 is thus formed to cover the aperture portion 14a and its surrounding insulating layer 14. Note that the underlayer 15 may also be fabricated using other dry methods.

Next, the liquid material 16a is applied onto the underlayer 15 by an application method (Fig.4(d), Fig.5(d)).
The underlayer 15 is lyophilic and the lyophobized surface A of the surrounding insulating layer 14 thereof is lyophobic. Therefore the liquid material 16a applied onto the underlayer 15 is repelled by the lyophobized surface A of the insulating layer 14, and does not flow onto the insulating layer 14 but rather seeks to stop on the lyophilic underlayer 15.
The liquid material 16a is thus disposed on the patterned underlayer 15.

Next, the liquid material 16a is dried and the thin film layer 16 is formed on the underlayer 15 (Fig.4(e), Fig.5(e)).
The thin film layer 16 comprised of organic EL material is formed on the underlayer 15 by drying the liquid material 16a.
Furthermore, the electrode 17 and the oxidation protection layer 18 are formed by vacuum deposition or the like after the liquid material 16a is dried, thereby producing the organic EL device 10 shown in Fig.3.

### (Fourth Embodiment)

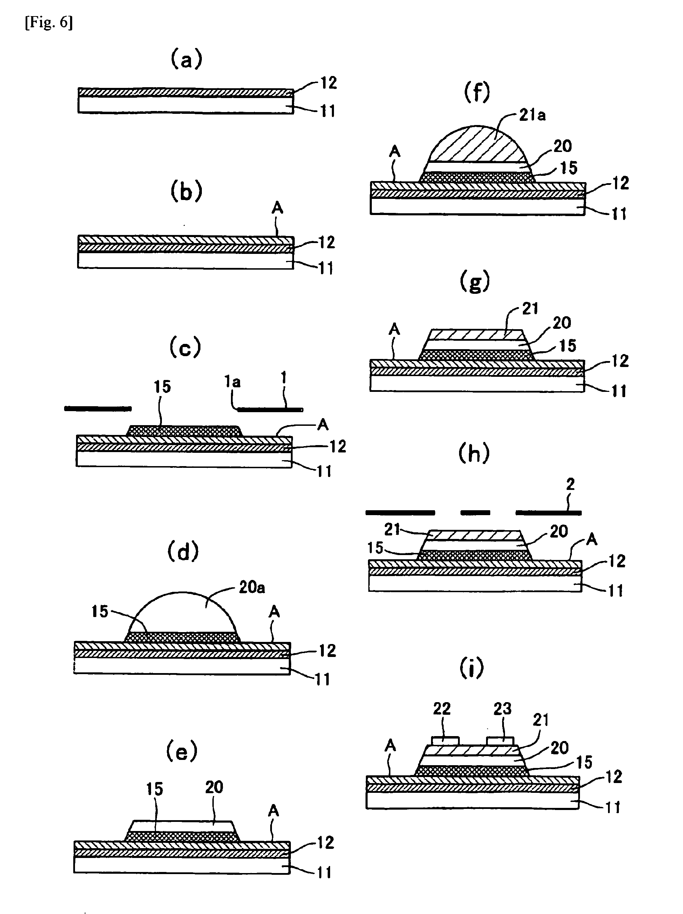

Next, referring to Fig.6, we discuss a method for forming a thin film according to a fourth embodiment of the present invention.
The fourth embodiment is an embodiment for producing a semiconductor device using the thin film forming method of the present invention. Fig.6 depicts the film forming steps according to this fourth embodiment of the present invention.

First, as shown in Fig.6(a), a substrate 11 is prepared on which material layer 12 is formed.
Next, as shown in Fig.6(b), the material layer 12 on the substrate 11 is subjected to lyophobization and a lyophobized surface A is formed on the material layer 12.

Next, as shown in Fig.6(c), the underlayer 15 with a prescribed pattern for gate electrodes is formed on the lyophobized surface A by a dry method such as vacuum deposition or the like using a mask 1 having a prescribed pattern.
Next, as shown in Fig.6(d), a liquid material 20a, in which an insulating material is dissolved in a solvent, is applied onto the underlayer 15 which functions as a gate electrode.
Next, as shown in Fig.6(e), the liquid material 20a applied onto the underlayer 15 is dried and the insulating layer 20 is formed on the underlayer 15. Note that the insulating layer 20 is now lyophilic.

Next, as shown in Figs.6(f) and 6(g), a liquid material 21 a, in which semiconductor material is dissolved in a solvent, is applied onto the lyophilic insulating layer 20 and dried. A semiconductor layer 21 is thus formed on the insulating layer 20.
Next, as shown in Fig.6(h), a mask 2 with a prescribed pattern is disposed above the substrate 1. The mask 2 is provided with patterns for forming source and drain electrodes.
As shown in Fig.6(i), a source electrode 22 and a drain electronic 23 are formed on the semiconductor layer 21 by vacuum deposition or the like, thereby producing a semiconductor device.

As described in each of the above embodiments of the present invention, a lyophobized surface A is pre-formed on a substrate 11, and a lyophilic underlayer 15 or insulating layer 20 having a prescribed pattern shape is formed on that lyophobized surface A. The liquid materials 16a, 20a, and 21 a are thereby disposed in this lyophilic pattern shape by an application method. Since the area outside the lyophilic pattern shape is at this point the lyophobized surface A, the liquid materials 16a, 20a, and 21a can be kept in the lyophilic pattern shape, and drying this can form a thin film layer 16, insulating layer 20, or semiconductor layer 21 having the same pattern shape as the lyophilic pattern shape.

Thus in each of the embodiments of the present invention the thin film layer formed by drying a liquid material enables the formation of fine prescribed pattern shapes without requiring the formation of a partitioning wall layer by time-consuming photolithography methods or the like as was done in the past. The production process can therefore be simplified, yield losses can be reduced, and production costs can be lowered.

Below we discuss specific examples in which an organic electroluminescent device was produced.

### (Example 1)

A substrate was prepared, in which a first electrode of indium tin oxide (ITO) is patterned on a transparent glass substrate.
Next, a positive photoresist (Tokyo Ohka: OFPR-800) was applied onto the entire surface by spin coating, then dried to form a photoresist layer with a film thickness of 1 µm.
Next, exposure with ultraviolet radiation was conducted by an aligner using a photomask designed to cover the ITO edge, and the photoresist in the exposed area was then removed using a resist developer (Tokyo Ohka: NMD-3). The substrate was then annealed for one hour at 230°C on a hot plate and the photoresist was completely heat-harded to produce an organic insulating layer.

Next, a lyophobization treatment on the insulating layer surface was performed by a vacuum plasma device using CF₄ gas.
Next, the underlayer comprising molybdenum oxide was patterned by resistance heating using a vacuum deposition machine through a metal mask designed to have an aperture covering at least the ITO exposed area (aperture portion).

### (Evaluation 1)

The results of measuring the contact angles on the insulating layer and the underlayer with anisole (surface tension 35 dyn/cm) using an automatic contact angle measuring device (EIKO Instruments Co. Ltd.: OCA20) were: 48.7° on the organic insulating layer and less than 10° on the underlayer. It was thus confirmed that the insulating layer was a lyophobized surface and the underlayer was a lyophilic surface.

Next, a liquid material containing a mixture of Aldrich MEH-PPV (poly (2-metoxy-5-(2'-ethyl-hexyloxy)-para-phenylene vinylene), about 1/200000% weight-average molecular weight toluene and anisole was prepared as the thin film forming material (i.e., ink); the ink (solution) was then applied by nozzle coating onto the molybdenum oxide layer serving as the underlayer; this was dried to produce an organic electroluminescent layer (light-emitting layer) with a film thickness of 1000 Å.

### (Evaluation 2)

The area around the ITO aperture portion was observed using an optical microscope; observation of the light-emitting layer pattern formation confirmed that the light-emitting layer had been formed favorably on the underlayer.

Calcium was then deposited up to a thickness of 100 Å (angstrom) as a second electrode, and silver was deposited up to a thickness of 2000 Å (angstrom) as an oxidation protection layer. An organic EL device with a bottom emission structure was thus produced.

### (Evaluation 3)

The ITO electrode (first electrode) side was connected as a positive electrode and the metal electrode (second electrode) side was connected as a negative electrode; a DC current was applied using a source meter, and observation of the light-emitting portion confirmed that a favorable light-emitting state had been obtained.

### (Example 2)

A device was produced by the same processes as used in Example 1, except that CF₄ gas was used as the reaction gas and lyophobization treatment was performed by an atmospheric pressure plasma device.

### (Evaluation 1)

After plasma treatment, the contact angle was measured using an automatic contact angle measuring device (EIKO Instruments Co. Ltd.: OCA20) with anisole (surface tension 35 dyn/cm); the results were 52.4° on the organic insulating layer and less than 10° on the underlayer. It was thus confirmed that the insulating layer was a lyophobized surface and the underlayer was a lyophilic surface.

### (Evaluation 2)

After forming a light-emitting area, the area around the ITO aperture portion was observed using an optical microscope; observation of the light-emitting layer pattern formation confirmed that the light-emitting layer had been formed favorably on the underlayer.

### (Evaluation 3)

The ITO electrode (first electrode) side was connected as a positive electrode and the metal electrode (second electrode) side was connected as a negative electrode; a DC current was applied using a source meter, and observation of the light-emitting portion confirmed that a favorable light-emitting state had been obtained.

### (Example 3)

A first electrode of Indium tin oxide (ITO) was patterned on a transparent glass substrate.
Next, a silicon oxide layer with a film thickness of 2000 Å (angstrom) was formed by sputtering.
Next, a positive photoresist (Tokyo Ohka: OFPR-800) was applied onto the entire surface by sputtering, then dried to form a photoresist layer with a film thickness of 1 µm.
Next, exposure with ultraviolet radiation was conducted by an aligner using a photomask designed to cover the ITO edge, and the photoresist in the exposed area was then removed using a resist developer (Tokyo Ohka: NMD-3).

Next, silicon oxide was etched by a vacuum dry etching device, using a gas mixture of CF₄ and oxygen. The photoresist layer was then peeled off to form an inorganic insulating layer.
Next, as a lyophobization treatment, fluoroalkyl silane (Tochem Products: MF-160E) was spin coated and dried to form a lyophobized layer.
Next, the underlayer of molybdenum oxide was patterned by resistance heating using a vacuum deposition machine through a metal mask designed to have an aperture covering at least the ITO exposed area (aperture portion).

### (Evaluation 1)

The results of measuring the contact angles on the insulating layer and the underlayer with anisole (surface tension 35 dyn/cm) using an automatic contact angle measuring device (EIKO Instruments Co. Ltd.: OCA20) were: 60.5° on the organic insulating layer and less than 10° on the underlayer. It was thus confirmed that the insulating layer was a lyophobized surface and the underlayer was a lyophilic surface.

Next, a liquid material containing a mixture of Aldrich MEH-PPV (poly (2-metoxy-5-(2'-ethyl-hexyloxy)-para-phenylene vinylene), about 1/200000% weight-average molecular weight toluene and anisole was prepared as the thin film forming material (i.e., ink); the ink (solution) was then applied by nozzle coating onto the molybdenum oxide layer serving as the underlayer; this was dried to produce an organic electroluminescent layer (light-emitting layer) with a film thickness of 1000 Å (angstrom).

### (Evaluation 2)

The area around the ITO aperture portion was observed using an optical microscope; observation of the light-emitting layer pattern formation confirmed that the light-emitting layer had been formed favorably on the underlayer.

Calcium was then deposited up to a thickness of 100 Å (angstrom) as a second electrode, and silver was deposited up to a thickness of 2000 Å (angstrom) as an oxidation protection layer.

### (Evaluation 3)

The ITO electrode side was connected as a positive electrode and the metal electrode side was connected as a negative electrode; a DC current was applied using a source meter, and observation of the light-emitting portion confirmed that a favorable light-emitting state had been obtained.

### (Example 4)

In Example 4, an organic EL device with a top emission structure was produced.

A substrate was prepared, in which a laminate formed of Cr as a first electrode and indium tin oxide (ITO) in turn is patterned on a transparent glass substrate.
Next, a positive photoresist (Tokyo Ohka: OFPR-800) was applied onto the entire surface by spin coating, then dried to form a photoresist layer with a film thickness of 1 µm.
Next, exposure to ultraviolet radiation was carried out by an aligner using a photomask designed to cover the ITO edge, and the photoresist in the exposed area was then removed using a resist developer (Tokyo Ohka: NMD-3). The substrate was then annealed for one hour at 230° C on a hot plate and the photoresist was completely heat-harded to produce an organic insulating layer.

Next, a lyophobization treatment on the insulating layer surface was performed by a vacuum plasma device using CF₄ gas.
Next, the underlayer of molybdenum oxide was patterned by resistance heating using a vacuum deposition machine through a metal mask designed to have an aperture covering at least the ITO exposed area (aperture portion).

### (Evaluation 1)

The results of measuring the contact angles on the insulating layer and the underlayer with anisole (surface tension 35 dyn/cm) using an automatic contact angle measuring device (EIKO Instruments Co. Ltd.: OCA20) were: 48.7° on the organic insulating layer and less than 10° on the underlayer. It was thus confirmed that the insulating layer was a lyophobized surface and the underlayer was a lyophilic surface.

Next, a liquid material containing a mixture of Aldrich MEH-PPV (poly (2-metoxy-5-(2'-ethyl-hexyloxy)-para-phenylene vinylene), about 1/200000% weight-average molecular weight toluene and anisole was prepared as the thin film forming material (i.e., ink); the ink (solution) was then applied by nozzle coating onto the molybdenum oxide layer serving as the underlayer; this was dried to produce an organic electroluminescent layer (light-emitting layer) with a film thickness of 1000 Å (angstrom).

### (Evaluation 2)

The area around the ITO aperture portion was observed using an optical microscope; observation of the light-emitting layer pattern formation confirmed that the light-emitting layer had been formed favorably on the underlayer.

As a second electrode, calcium was then deposited in a thickness of 100 Å (angstrom), aluminum was deposited in a thickness of 50 Å (angstrom), a 2000 Å (angstrom) thick transparent electrode layer was then further deposited on the indium tin oxide (ITO) as a target using a facing target deposition device. An organic EL device with a top emission structure was thus produced.

### (Evaluation 3)

The Cr and ITO laminate-side electrode was connected as a positive electrode and the ITO-only electrode side was connected as a negative electrode; a DC current was applied using a source meter, and observation of the light-emitting portion confirmed that a favorable light-emitting state had been obtained in the direction opposite to the glass substrate side.

### (Comparative Example 1)

A device was produced using all of the same processes as Example 1 except that no lyophobization treatment was performed therein.

### (Evaluation 1)

The results of measuring the contact angles on the insulating layer and the underlayer with anisole (surface tension 35 dyn/cm) using an automatic contact angle measuring device (EIKO Instruments Co. Ltd.: OCA20) were: 12° on the organic insulating layer and less than 10° on the underlayer. It was thus confirmed that both the insulating layer and the underlayer were lyophilic surfaces.

### (Evaluation 2)

After forming the organic electroluminescent layer, the area around the ITO aperture portion was observed using an optical microscope; observation of the light-emitting layer pattern formation confirmed that the light-emitting layer had spread to be much wider than the width of the underlayer.

### (Evaluation 3)

The ITO electrode (first electrode) side was connected as a positive electrode and the metal electrode (second electrode) side was connected as a negative electrode; a DC current was applied using a source meter, whereupon shorting occurred between the two electrodes and no light emission could be confirmed.

**Table 1**

| | | | Example 1 | Example 2 | Example 3 | Comparative Example 1 |
|---|---|---|---|---|---|---|
| Structure | Insulating Layer | | Organic Substance | Organic Substance | Inorganic Substance | Organic Substance |
| | Underlayer | | Inorganic (MoO) | Inorganic (MoO) | Inorganic (MoO) | Inorganic (MoO) |
| | Lyophobization Treatment | | Vacuum Plasma | Atmospheric Pressure Plasma | Apply lyophobic material | None |
| Evaluation 1 | Ink Contact Angle | On insulating layer | 48.7° | 52.4° | 60.5° | 12° |
| | | On underlayer | Under 10° | Under 10° | Under 10° | Under 10° |
| Evaluation 2 | Pattern formation state | | Good | Good | Good | Wider than width of underlayer. |
| Evaluation 3 | Light-emitting state | | Good | Good | Good | Electrical continuity between electrodes; no light emission obtained. |

### Brief Explanation of the Drawings

- Fig. 1: A diagram showing a thin film forming process according to a first embodiment of the present invention.
- Fig. 2: A diagram showing a thin film forming process according to a second embodiment of the present invention.
- Fig. 3: A cross section of an organic electroluminescent device produced according to a third embodiment of the present invention.
- Fig. 4: A diagram showing a production process for the organic electroluminescent device in Fig. 3.
- Fig. 5: A diagram showing a production process for the organic electroluminescent device in Fig. 3.
- Fig. 6: A diagram showing a production process for a semiconductor device according to a fourth embodiment of the present invention.
- Fig. 7: A diagram showing a thin film forming process in the conventional art.

### Explanation of the Reference Numerals

- 1: Mask
- 1a: Aperture portion
- 2: Mask
- 10: Organic electroluminescent device
- 11: Substrate
- 12: Material layer
- 13: Electrode
- 14: Insulating layer
- 14a: Aperture portion
- 15: Underlayer
- 16: Thin film layer
- 16a: Liquid material
- 17: Electrode
- 18: Oxidation protection layer
- 20: Insulating layer
- 20a: Liquid material
- 21: Semiconductor layer
- 21 a: Liquid material
- 22: Source electrode
- 23: Drain electrode
- A: Lyophobized surface

## Claims

1. A method by which a liquid material containing a thin film forming material is applied to a substrate to form a thin film in a prescribed region, the method comprising:
a step of subjecting the substrate to lyophobization;
a step of patterning an underlayer on a lyophobized surface of the substrate, the underlayer being more lyophilic to the liquid material than the lyophobized surface; and
a step of applying the liquid material to the underlayer and then drying it.

2. The thin film forming method according to claim 1, wherein in the step of patterning the underlayer, the underlayer is formed by a dry method.

3. The thin film forming method according to claim 1 or 2, wherein the underlayer is a layer comprising a metal oxide or a metal composite oxide.

4. The thin film forming method according to claim 3, wherein the metal oxide or the metal composite oxide is any of vanadium oxide, molybdenum oxide, ruthenium oxide, aluminum oxide, nickel oxide, barium titanate, and strontium titanate.

5. The thin film forming method according to claim 1 or 2, wherein the underlayer is a layer comprising an organic material insoluble in the liquid material.

6. The thin film forming method according to any one of claims 1 to 5, wherein in the step of patterning the underlayer, an edge of the underlayer is formed into a forward tapered shape.

7. The thin film forming method according to any one of claims 1 to 6, wherein in the step of patterning the underlayer, a pattern of the underlayer is formed in the same region of the thin film as the prescribed region.

8. The thin film forming method according to any one of claims 1 to 7, wherein in the step of patterning the underlayer, a pattern of the underlayer is formed on a conductive material partitioned with an insulating material.

9. The thin film forming method according to claim 1, wherein the lyophobization is a vacuum plasma treatment including a fluorine-containing gas, an atmospheric pressure plasma treatment including a fluorine-containing gas, or a treatment comprising applying a lyophobic material to the substrate.

10. The thin film forming method according to any one of claims 1 to 9, wherein the step of applying the liquid material and drying it is repeated multiple times using the same liquid material.

11. The thin film forming method according to any one of claims 1 to 9, wherein the step of applying the liquid material and drying it is repeated multiple times using different liquid materials.

12. A method for producing an organic electroluminescent device using the thin film forming method according to any one of claims 1 to 11.

13. A method for producing a semiconductor device using the thin film forming method according to any one of claims 1 to 11.

14. A method for producing an optical device using the thin film forming method according to any one of claims 1 to 11.
